# EUROPEAN PATENT SPECIFICATION

(11) **EP 4 089 665 B1**
(45) Date of publication and mention of the grant of the patent: **18.06.2025**
(21) Application number: 20912729.9
(22) Date of filing: 06.01.2020
(51) Int. Cl.: G09F 9/33, G06F 1/16, G09F 9/30

(54) **DISPLAY DEVICE**
ANZEIGEVORRICHTUNG
DISPOSITIF D'AFFICHAGE

(43) Date of publication of application: 16.11.2022
(73) Proprietor: LG Electronics, Inc., Yeongdeungpo-gu Seoul 07336 (KR)
(72) Inventor: LEE, Dabin, Seoul 06772 (KR); KIM, Huisik, Seoul 06772 (KR); RYU, Jaeuk, Seoul 06772 (KR); KIM, Mikyung, Seoul 06772 (KR); SHO, Weonyoung, Seoul 06772 (KR)
(74) Representative: Vossius & Partner Patentanwälte Rechtsanwälte mbB
(86) International application number: PCT/KR2020/000194
(87) International publication number: WO 2021/141144

(56) References cited:
- EP-A1- 3 671 404
- KR-A- 20150 015 276
- KR-A- 20160 141 263
- KR-B1- 101 577 336
- KR-B1- 101 945 890
- US-A1- 2012 281 367
- US-A1- 2013 170 156
- US-A1- 2018 329 254
- US-B2- 8 736 782

## Description

### [Technical Field]

The present disclosure relates to a display device.

### [Background Art]

With the development of the information society, there have been growing demands for various types of display devices, and in order to meet these demands, research has been conducted thereon and various display devices have been used recently, including a liquid crystal display (LCD), a plasma display panel (PDP), an electroluminescent display (ELD), a vacuum fluorescent display (VFD), and the like.

Among them, a display device using an organic light emitting diode (OLED) has excellent luminance and viewing angle characteristics in comparison with a liquid crystal display device, and requires no backlight unit, such that the OLED display device can be implemented as an ultrathin display device.

In addition, according to recent development and consumption trends of the display device, a lot of research has been done to manufacture the display device with a thinner and lighter structure.

EP 3 671 404 A1 is prior art under Article 54(3) EPC and relates to a display device which visually displays information in characters, graphs or figures.

US 2013/170156 A1 relates to a display device which has light weight and minimizes concentration of heat at a specific region.

### [Disclosure of Invention]

### [Technical Problem]

It is an object of the present disclosure to solve the above and other problems.

It is another object of the present disclosure to provide a display device in which a component for securing rigidity may also serve as an exterior material.

It is yet another object of the present disclosure to provide a display device capable of facilitating product assembly and providing an optimal internal space.

### [Technical Solution]

In accordance with an aspect of the present disclosure, the above and other objects is accomplished by providing a display device according to claim 1.

### [Advantageous Effects]

The display device according to the present disclosure has the following effects.

According to at least one of the embodiments of the present disclosure, it is possible to provide a display device in which a component for securing rigidity may also serve as an exterior material.

According to at least one of the embodiments of the present disclosure, it is possible to provide a display device capable of facilitating product assembly and providing an optimal internal space.

Further scope of applicability of the present disclosure will become apparent from the detailed description given hereinafter. However, it should be understood that the detailed description and specific examples, while indicating preferred embodiments of the present disclosure, are given by illustration only, since various changes and modifications within the scope of the present disclosure will become apparent to those skilled in the art from this detailed description.

### [Brief Description of Drawings]

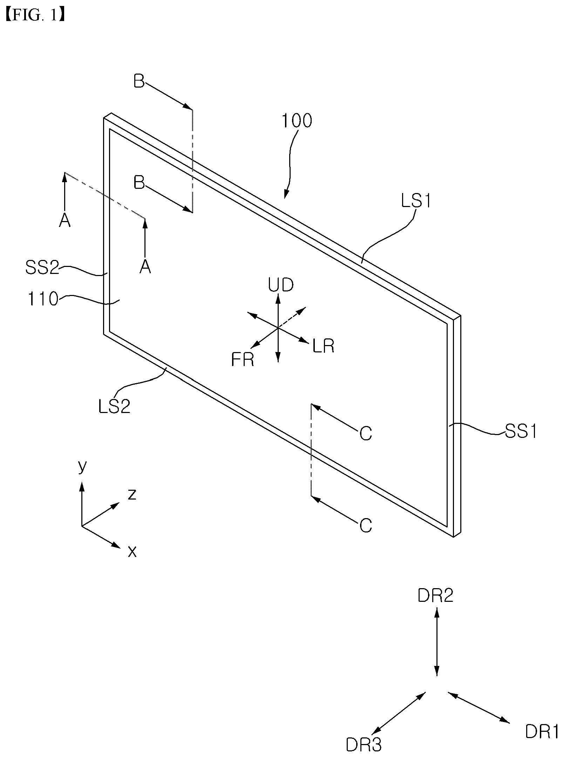

FIGS. 1 to 13 are diagrams illustrating examples of a display device according to embodiments of the present disclosure.

### [Mode for Carrying Out the Invention]

Hereinafter, the present disclosure will be described in detail with reference to the accompanying drawings, in which the same reference numerals are used throughout the drawings to designate the same or similar components, and a redundant description thereof will be omitted.

The terms "module" and "unit" for elements used in the following description are given simply in view of the ease of the description, and do not have a distinguishing meaning or role.

Further, it will be noted that a detailed description of known arts will be omitted if it is determined that the detailed description of the known arts can obscure the embodiments of the invention. Further, the accompanying drawings are used to help easily understand various technical features and it should be understood that the embodiments presented herein are not limited by the accompanying drawings. As such, the present disclosure should be construed to extend to any alterations and substitutes in addition to those which are particularly set out in the accompanying drawings.

It will be understood that, although the terms first, second, etc., may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, the singular forms are intended to include the plural forms as well, unless the context clearly indicates otherwise.

In the following description, even if an embodiment is described with reference to a specific figure, if necessary, reference numeral not shown in the specific figure may be referred to, and reference numeral not shown in the specific figure is used when the reference numeral is shown in the other figures.

Referring to FIG. 1, a display device 100 may include a display panel 110. The display panel 110 may display images.

The display device 100 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated and described that the first and second long sides LS1 and LS2 are longer than the first and second short sides SS1 and SS2, but there may also be a case in which lengths of the first and second long sides LS1 and LS2 may be approximately equal to lengths of the first and second short sides SS1 and SS2.

A direction parallel to the first and second long sides LS1 and LS2 of the display device 100 may be referred to as a first direction DR1 or a left-right direction LR. A direction parallel to the first and second short sides SS1 and SS2 of the display device 100 may be referred to as a second direction DR2 or an up-down direction UD. A direction perpendicular to the long sides LS1 and LS2 and the short sides SS1 and SS2 of the display device 100 may be referred to as a third direction DR3 or a front-rear direction FR. Here, a side on which the display device 100 displays an image may be referred to as a front side, and a side opposite thereto may be referred to as a rear side.

In the following description of the display panel 110, a display panel using an Organic Light Emitting Diode (OLED) will be described as an example, but the display panel 110 which may be applied to the present disclosure is not limited thereto.

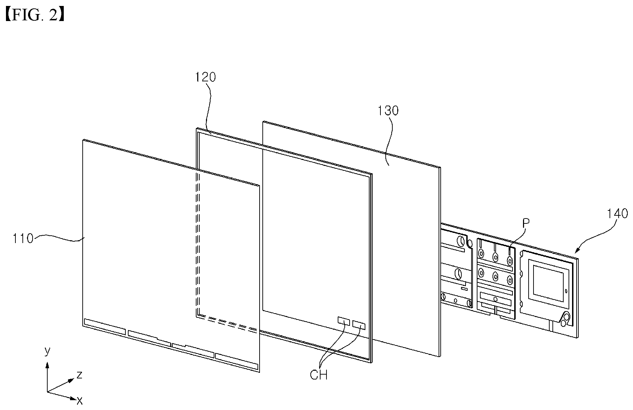

Referring to FIG. 2, the display device 100 includes the display panel 110, a frame 120, a corrugated panel 130, and a mount 140.

The display panel 110 may form a front surface of the display device 100 and may display an image on the front side. The display panel 110 may divide the image into a plurality of pixels and may output the image while controlling color, brightness, and chroma of the respective pixels. The display panel 110 may be divided into an active area, in which the image is displayed, and a de-active area in which the image is not displayed. The display panel 110 may generate light corresponding to red, green, or blue color in response to a control signal.

The frame 120 may form side surfaces of the display device 100. The frame 120 is disposed at the rear of the display panel 110 and is coupled to the display panel 110. The frame 120 may have an overall square ring shape. For example, the frame 120 may be formed of a metal material. For example, the frame 120 may be formed of an aluminum (Al) material.

The corrugated panel 130 may form a rear surface of the display device 100. The corrugated panel 130 is disposed at the rear of the display panel 110 and is coupled to the frame 120.

The mount 140 is coupled to a rear surface of the corrugated panel 130. A PCB P electrically connected to the display panel 110 via a cable C is installed in the mount 140. The PCB P may control image display of the display panel 110. The PCB P may be referred to as a source PCB.

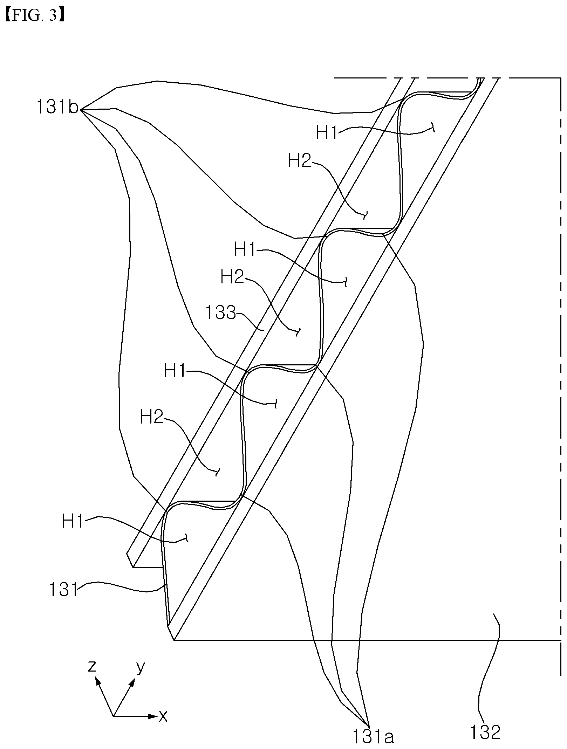

Referring to FIG. 3, the corrugated panel 130 includes a core 131, a front skin 132, and a rear skin 133. The core 131, the front skin 132, and the rear skin 133 may be coupled to each other.

The front skin 132 forms a front surface of the corrugated panel 130. The rear skin 132 forms a rear surface of the corrugated panel 130. The front skin 132 and the rear skin 133 may be formed of a metal material. For example, the front skin 132 and the rear skin 133 may be formed of an aluminum (Al) material. For example, the front skin 132 and the rear skin 133 may have a thickness of about 0.5 mm. The front skin 132 and the rear skin 133 may be disposed opposite to each other with respect to the core 131 which will be described below.

The core 131 is disposed between the front skin 132 and the rear skin 133. The core 131 may have a corrugated shape with alternating ridges 131a and grooves 131b which are elongated. For example, the core 131 may have a wavy, corrugated shape. For example, the core 131 may have a thickness of about 0.15 mm.

For example, the ridges 131a and the grooves 131b may be elongated in the left-right direction LR which is an elongated direction of the display panel 110. Here, the direction in which the ridges 131a and the grooves 131b are elongated may be defined as a longitudinal direction of the core 131. In this case, a plurality of ridges 131a may be spaced apart from each other in the up-down direction UD. In addition, a plurality of grooves 131b may be spaced apparat from the ridges 131a in the up-down direction UD. For example, a length between the plurality of ridges 131a or a pitch which is a length between the plurality of grooves 131b may be about 7 mm. In addition, the ridges 131a or the grooves 131b may have a height of about 3 mm.

For example, the ridges 131a may come into contact with an inner surface of the front skin 132, and the grooves 131b may come into contact with an inner surface of the rear skin 131. By contrast, it is also possible that the ridges 131a come into contact with the inner surface of the rear skin 133, and the grooves 131b come into contact with the inner surface of the front skin 132, but a description thereof will be omitted for convenience of explanation.

A first hole H1 may be formed between the core 131 and the front skin 132. The first hole H1 may include a plurality of first holes H1 which are spaced apart from each other with the respective ridges 131a being disposed therebetween. A second hole H2 may be formed between the core 131 and the rear skin 133. The second hole H2 may include a plurality of holes H2 which are spaced apart from each other with the respective ridges 131a being disposed therebetween. The respective first and second holes H1 and H2 may be elongated in the left-right direction LR. The first and second holes H1 and H2 may pass through the left and right sides of the corrugated panel 130.

Accordingly, the corrugated panel 130 having the core 131 and the display panel 110 coupled thereto may have improved rigidity.

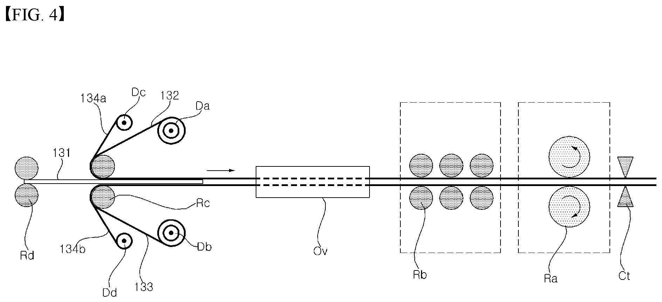

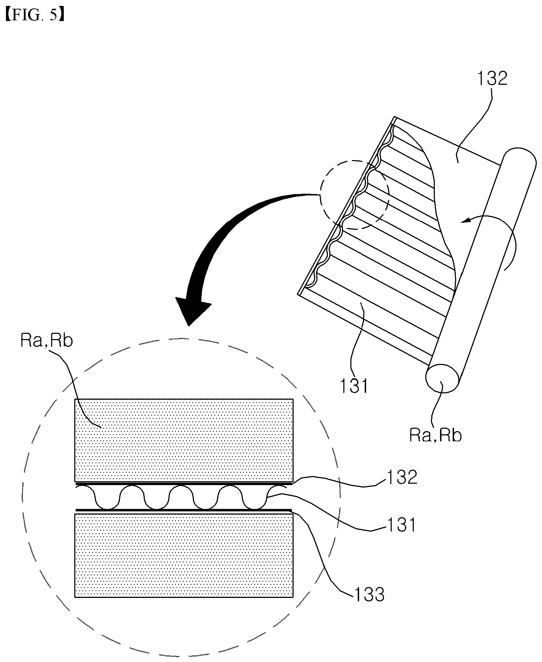

Referring to FIGS. 4 and 5, the corrugated panel 130 may be manufacture in a process of pressing the front skin 132 and the rear skin 133 onto the core 131 using a plurality of rollers, and the process may be referred to as Roll-to-Roll (R2R) processing.

Referring to FIG. 4, by the rotation of a pinch roller Ra serving as a driving motor, the front skin 132 is unwound from a front drum Da, the rear skin 133 is unwound from a rear drum Db, and the core 131 may be moved by passing through a feeding roller Rd. Further, a first adhesive 134a for coupling the front skin 132 to the core 13 may be unwound from a first drum Dc. In addition, a second adhesive 134b for coupling the rear skin 133 to the core 131 may be unwound from a second drum Db. In this case, the front skin 132, the first adhesive 134a, the core 131, the second adhesive 134b, and the rear skin 133 are stacked in this order, and may be guided by a guide roller Rc toward an oven Ov.

As the first and second adhesives 134a and 134b are melted in the oven Ov, each of the front skin 132 and the rear skin 133 may be coupled to the core 131. That is, the first and second adhesives 134a and 134b may be hot-melt adhesives. For example, the first and second adhesives 134a and 134b may have a melting point of about 150 °C, and the ambient temperature of the oven Ov may be about 200 °C. For example, the peel-off force of the first and second adhesives 134a and 134b may be about 10 kgf or more.

Having passed through the oven Ov, the front skin 132, the core 131, and the rear skin 133 may be guided to a press roller Rb by the rotation of the pinch roller Ra, to be pressed by the press roller Rb. Accordingly, the front skin 132, the core 131, and the rear skin 133 may be coupled to each other with an improved coupling force. After passing through the pinch roller Ra, the front skin 132, the core 131, and the rear skin 133, which are coupled to each other, may be cut by a cutter Ct, to be manufactured as the corrugated panel 130 of a predetermined size.

Referring to FIG. 5, the press roller Rb or the pinch roller Ra may come into contact with an outer surface of each of the front skin 132 and the rear skin 133. The press roller Rb or the pinch roller Ra may be elongated in a direction (e.g., up-down direction UD) in which the ridges 131a and the grooves 131b of the core 131 are alternately formed. That is, when the press roller Rb or the pinch roller Ra is rotated, the corrugated panel 130 may be moved in a longitudinal direction (i.e., left-right direction LR) of the core 131. In this case, the front skin 132 and the rear skin 133 may be coupled to the core 131 sequentially from one end to the other end in the longitudinal direction of the core 131. In this case, force applied by the press roller Rb or the pinch roller Ra may be distributed evenly over the plurality of ridges 131a or the plurality of grooves 131b. Accordingly, the front skin 132 and the rear skin 133, passing through the press roller Rb or the pinch roller Ra, may be prevented from being recessed inwardly toward the core 131. In addition, the front skin 132 and the rear skin 133 of the corrugated panel 130 may be formed to be flat. That is, a flat rear surface of the rear skin 133, which forms the rear surface of the display device 100, may improve surface quality per se. Further, additional operations, such as painting the rear surface of the rear skin 133, attaching a sheet thereto, or the like, may be performed easily to improve the outer appearance in the esthetic sense.

In comparison, the press roller Rb or the pinch roller Ra may be elongated in a longitudinal direction (e.g., left-right direction LR) of the ridges 131a and the grooves 131b of the core 131. That is, when the press roller Rb or the pinch roller Ra are rotated, the corrugated panel 130 may be moved in a direction perpendicular to the longitudinal direction of the core 131. In this case, the front skin 132 and the rear skin 133 may be coupled to the core 131 sequentially from one end to the other end in the direction perpendicular to the longitudinal direction of the core 131. In this case, the force applied by the press roller Rb or the pinch roller Ra may be applied individually to the respective ridges 131a or the respective grooves 131b. Accordingly, the front skin 132 and the rear skin 133 passing through the press roller Rb or the pinch roller Ra may be recessed inwardly, particularly at portions where the first and second holes H1 and H2 are formed. In addition, the front skin 132 and the rear skin 133 of the corrugated panel 130 may not be flat but may be formed unevenly.

Meanwhile, in addition to the R2R processing described above with reference to FIGS. 4 and 5, in which the front skin 132 and the rear skin 133 are formed to be flat, a process of sequentially stacking the front skin 132, the core 131, and the rear skin 133 followed by coupling the same may also be performed so that the front skin 132 and the rear skin 133 may be formed to be flat.

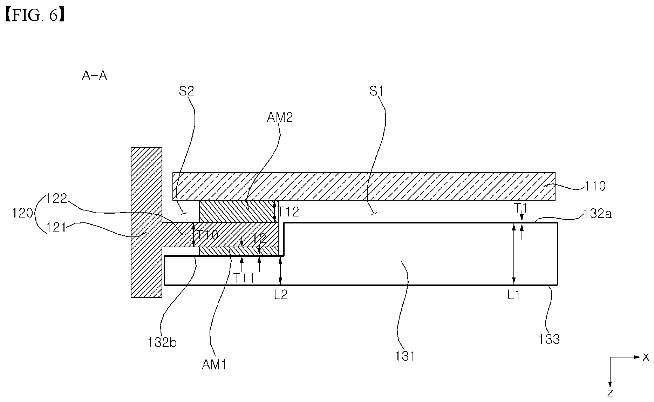

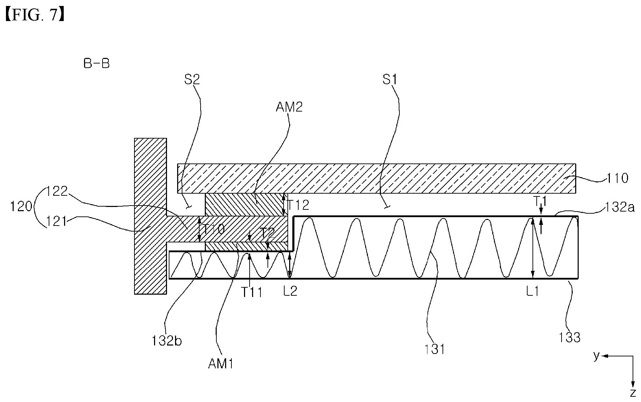

Referring to FIGS. 6 and 7, the frame 120 may include a side wall 121 and a base 122 (for reference, FIG. 6 is a cross-sectional view taken along line A-A of FIG. 1, and FIG. 7 is a cross-sectional view taken along line B-B of FIG. 1).

The side wall 121 may cover a side surface of the display panel 110 and a side surface of the corrugated panel 130. The side wall 121 may prevent surfaces on all sides of the display panel 110 and surfaces on all sides of the corrugated panel 130 from being exposed to the outside. Accordingly, a shape of the core 131 of the corrugated panel 130 may not be visible from the outside, thereby improving surface quality of the display panel 110. That is, the first and second holes H1 and H2 formed inside the corrugated panel 130 may not be exposed to the outside by the side wall 121. For example, the side wall 121 may be parallel to, or may protrude further forward than, the front surface of the display panel 110. For example, the side wall 121 may be parallel to, or may protrude further rearward than, the rear surface of the rear skin 133.

The base 122 may protrude from the side wall 121. For example, the base 122 may be integrally formed with the side wall 121. One side surface (i.e., rear surface) of the base 122 may be coupled to the front surface of the front skin 132, and the other surface (e.g., front surface) thereof may be coupled to the rear surface of the display panel 110. In this case, the front skin 132 may include a first skin 132a and a second skin 132b.

The first skin 132a may face the rear surface of the display panel 110. A front surface of the first skin 132a and the rear surface of the display panel 110 may form a first space S1. The second skin 132b may be recessed further rearwardly than the first skin 132a. The second skin 132b may face one side surface (i.e., rear surface) of the base 122. The other surface (i.e., front surface) of the base 122 and the rear surface of the display panel 110 may form a second space S2.

For example, by pressing a portion of the front skin 132, which is formed to be flat, with a pressing device, the second skin 132b distinguishable from the first skin 132a may be formed. In this case, a length L2 between the ridges and grooves of the core 131, disposed between the second skin 132b and the rear skin 133, may be smaller than a length L1 of the ridges and grooves of the core 131 disposed between the first skin 312a and the rear skin 133.

A first adhesive member AM1 may couple the base 122 to the second skin 132b. The first adhesive member AM1 may be disposed between one side surface (i.e., rear surface) of the base 122 and a front surface of the second skin 132b. For example, the first adhesive member AM1 may be an adhesive such as a double-sided tape. In this case, the front surface of the first skin 132a may be disposed parallel to the front surface of the base 122. To this end, a sum of the length L1 and a thickness T1 of the first skin 132a may be equal to a value obtained by adding a thickness T2 of the second skin 132b, a thickness T11 of the first adhesive member AM1, and a thickness T10 of the base 122 to the length L2. Here, the thickness T1 of the first skin 132a and the thickness T2 of the second skin 132b may be equal to each other.

The second adhesive member AM2 may couple the base 122 to the display panel 110. The second adhesive member AM2 may be disposed between the other side surface (i.e., front surface) of the base 122 and the rear surface of the display panel 110. For example, the second adhesive member AM2 may be an adhesive such as a double-sided tape. For example, a thickness T12 of the second adhesive member AM2 may be equal to or greater than the thickness T11 of the first adhesive member AM1.

Each of the first display panel 110 and the corrugated panel 130 may be firmly coupled to the base 122 by the first and second adhesive members AM1 and AM2, respectively. Accordingly, the display panel 110 may have sufficient rigidity by the corrugated panel 130.

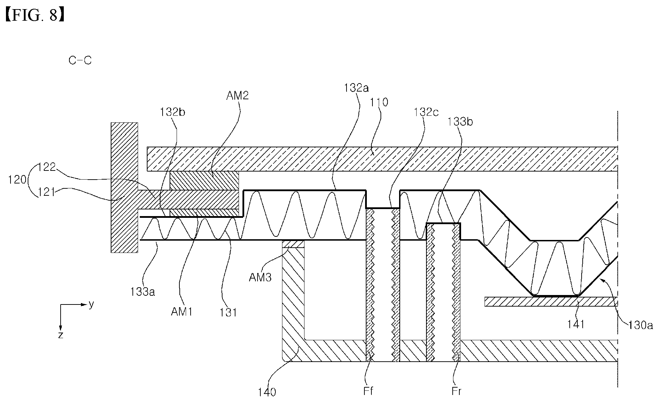

Referring to FIG. 8, the mount 140 is coupled to the rear surface of the rear skin 133 (for reference, FIG. 8 is a cross-sectional view taken along line C-C of FIG. 1). A third adhesive member AM3 couples the rear skin 133 to the mount 140. The third adhesive member AM3 is disposed between the rear surface of the rear skin 133 and the front surface of the mount 140. For example, the third adhesive member AM3 may be an adhesive such as a double-sided tape.

The front skin 132 includes a third skin 132c which is recessed further rearwardly than the first skin 132a, and has one side coupled to the other side of a front fastening member Ff coupled to the mount 140. For example, the front fastening member Ff may be a nut, and a bolt may be fastened to the nut, thereby increasing a coupling force between the mount 140 and the corrugated panel 130.

The rear skin 133 may include a fourth skin 133a and includes a fifth skin 133b. The fifth skin 133b protrudes of further forward than the fourth skin 133a, and has one side coupled to the other side of a rear fastening member Fr coupled to the mount 130. For example, the rear fastening member Fr may be a nut, and a bolt may be fastened to the nut, thereby increasing a coupling force between the mount 140 and the corrugated panel 130.

For example, a portion of the corrugated panel 130 may protrude rearward to form a foaming portion 130a. In this case, among internal components of the mount 130, any one component 141 may be coupled to the foaming portion 130a.

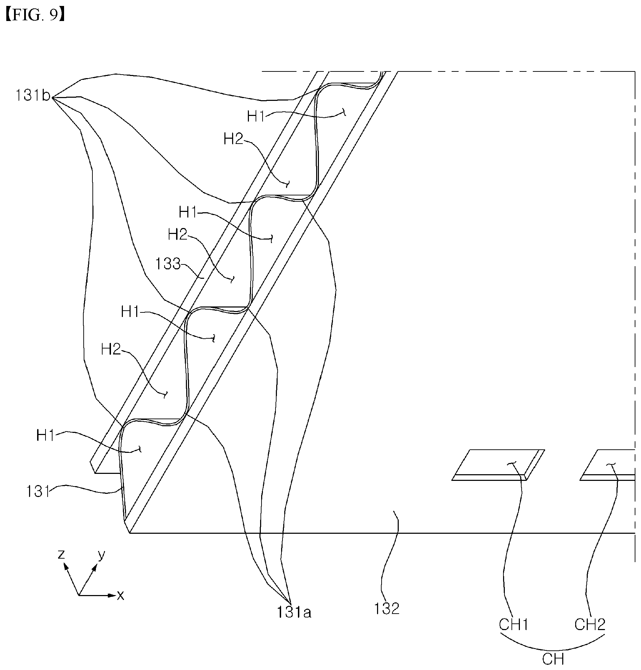

Referring to FIG. 9, the corrugated panel 130 may have at least one cable hole CH which is formed by passing through the front skin 132 and the rear skin 133. For example, the cable hole CH may be adjacent to a lower end of the corrugated panel 130.

The cable C for electrically connecting the display panel 110 and the PCB P may pass through the cable hole CH.

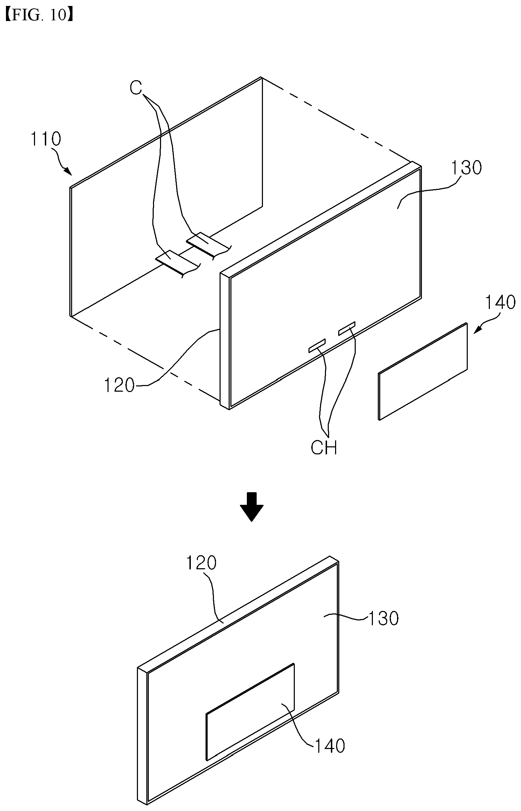

Referring to FIG. 10, the display panel 110, and the corrugated panel 130 coupled to the frame 120, may be moved close to each other in the front-rear direction FR, to be assembled as the display device 100.

Specifically, the cable C, having one end electrically connected to the display panel 110, may pass through the cable hole CH to be guided rearwardly. In this case, the cable C may be inserted into the mount 140, coupled to the rear surface of the rear skin 133, to be electrically connected to the PCB P.

Accordingly, the PCB P may control image display of the display panel 110 through the cable C. Further, a path is formed in which the cable C passing through the corrugated panel 130 is disposed, thereby facilitating assembly of the display device 100 and optimizing the internal space, when compared with a case where the cable C is disposed at a position spaced apart from a region where in the corrugated panel 130 is disposed. In addition, the cable hole CH and the cable C passing therethrough may be covered by the mount 140, and thus may not be visible from the outside, such that surface quality may be improved.

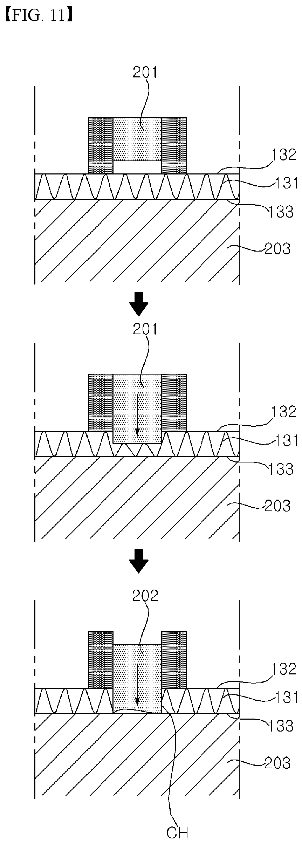

Referring to FIG. 11, the cable hole CH may be formed by at least one of the front skin 132 and the rear skin 131 which is depressed inwardly toward the core 131 and then is punched.

Specifically, the corrugated panel 130 may be mounted on a die 203, so that an outer surface of the rear skin 133 may come into contact with an upper surface of the die 203, and a pressing device 201 may be positioned at a portion of the front skin 132 at which the cable hole CH is to be formed. Then, the front skin 132 is locally plastically deformed by a depressing operation of the pressing device 201, to be maintained in an inwardly recessed state compared to other portions. Subsequently, a punching device 202 may be positioned at a portion of the front skin 132, at which the cable hole CH is to be formed. Next, the cable hole Ch may be formed by a punching operation of the punching device 202. Meanwhile, the cable hole CH may also be formed in such a manner that the corrugated panel 130 is mounted on the die 203 so that the outer surface of the front skin 132 may come into contact with the upper surface of the die 203, and the rear skin 133 is depressed inwardly by the pressing device 201, and then is punched by the punching device 202.

Accordingly, deformation of the core 131 adjacent to the cable hole CH may be minimized, compared to the case where the cable hole CH is formed by only punching without depressing the front skin 132 or the rear skin 133. That is, in the case where the cable hole CH is formed by only punching due to the first and second holes H1 and H2 positioned at portions where the cable hole CH is to be formed, the core adjacent to the cable hole CH may be deformed relatively greatly. By contrast, by compressing the size of the first and second holes H1 and H2, disposed at positions where the cable hole CH is to be formed, by the depressing operation, followed by punching, the influence of the first and second holes H1 and H2 may be reduced, thereby minimizing the deformation of the core 131 adjacent to the cable hole CH.

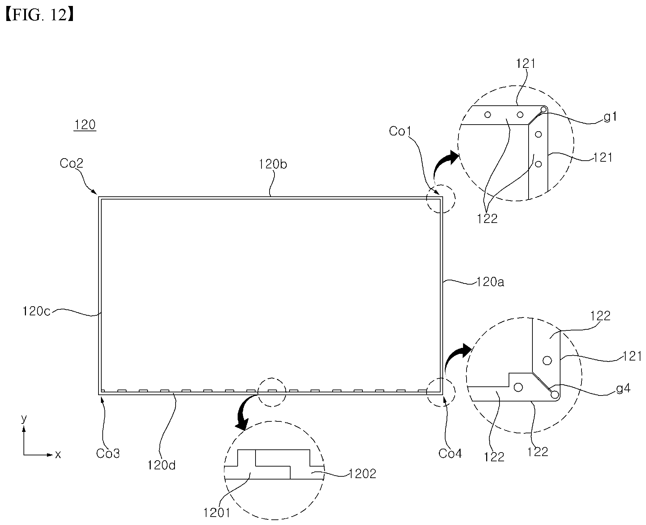

Referring to FIG. 12, each frame 120 includes the side wall 121 and the base 122 and may include a plurality of edges with corners Co formed therebetween. For example, the plurality of edges may include first to fourth edges 120a, 120b, 120c, and 120d. The first edge 120a may correspond to the first short side SS1, the second edge 120b may correspond to the first long side LS1, the third edge 120c may correspond to the second short side SS2, and the fourth edge 120d may correspond to the second long side LS2 (see FIG. 1). In this case, a first corner Co1 may be formed between the first and second edges 120a and 120b, and a second corner Co2 may be formed between the second and third edges 120b and 120c. In addition, a third corner Co3 may be formed between the third and fourth edges 120c and 120d, and a fourth corner Co4 may be formed between the fourth and first edges 120d and 120a.

For example, as the base 122 of each of the plurality of edges protrudes from the side wall 121, a length in a longitudinal direction thereof may decrease. Here, the longitudinal direction of each of the plurality of edges may refer to a direction toward the adjacent corner Co. In this case, in the front-rear direction FR, the base 122 of each of the plurality of edges may have a trapezoidal shape, with a portion coupled to the side wall 121 having a relatively greater length.

In addition, the base 122 of any one of the plurality of edges at the corner Co may be spaced apart from the base 122 of another one by a predetermined distance. For example, a first gap g1 may be formed between the bases of the respective first and second edges 120a and 120b at the first corner Co1, and a second gap g2 may be formed between the bases of the respective second and third edges 120b and 120c at the second corner Co2. Further, a third gap g3 may be formed between the bases of the respective third and fourth edges 120c and 120d at the third corner Co3, and a fourth gap g4 may be formed between the bases of the respective fourth and first edges 120d and 120a at the fourth corner Co4.

As described above, the first to fourth gaps g1, g2, g3, and g4 are formed such that the frame 120 may be manufactured by a bending process, which will be described below in further detail.

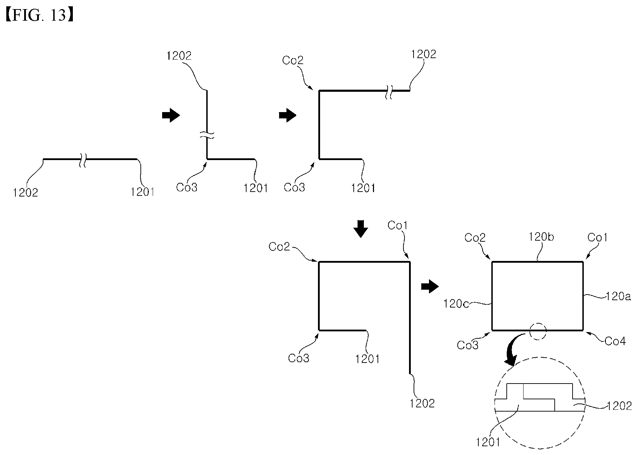

Referring to FIG. 13, the plurality of edges may be formed by bending the frame 120 a number of times corresponding to the number of corners Co. For example, the frame 120 may be formed in a straight shape by an extrusion process of aluminum (Al), then may be formed in an overall square ring shape by the bending process which will be described below. That is, the frame 120 having the straight shape may be bent four times by a bending device (not shown), thereby sequentially forming the third corner Co3, the second corner Co2, the first corner Co1, and the fourth corner Co4. As a result, the frame 120 may have the first to fourth edges 120a, 120b, 120c, and 120d. Further, it should be understood that in order to prevent the bases of the respective edges from interfering with each other during the bending process, the above first to fourth gaps g1, g2, g3, and g4 are formed.

In this case, one end 1201 and the other end 1202 of the frame 120 may be coupled to each other to form a closed loop. For example, the one end 1201 and the other end 1202 may be coupled to each other by welding. In this case, a welded portion may be subjected to an anodizing process after finishing. Accordingly, the welded portion may be neatly finished, thereby improving surface quality. In addition, as a film is formed by the anodizing process, the frame 120 may have improved corrosion resistance and may be easily colored. In addition, a bracket (not shown) for covering the welded portion may be provided, such that the welded portion may not be exposed to the outside.

According to an aspect of the present disclosure, there is provided a display device including: a display panel; a frame disposed at a rear of the display panel and to which the display panel is coupled; and a corrugated panel disposed at the rear of the display panel and to which the frame is coupled, wherein the corrugated panel includes: a front skin forming a front surface; a rear skin forming a rear surface and disposed opposite to the front skin; and a core disposed between the front skin and the rear skin and having a corrugated shape with alternating ridges and grooves which are elongated, wherein a rear surface of the rear skin is formed to be flat.

In addition, according to another aspect of the present disclosure, the front skin and the rear skin may be coupled to the core sequentially from one end to the other end in a longitudinal direction of the core.

In addition, according to another aspect of the present disclosure, the display panel may be elongated in the longitudinal direction of the core.

In addition, according to another aspect of the present disclosure, the frame may include: a side wall covering a side surface of the display panel and a side surface of the corrugated panel; and a base protruding from the side wall, and having one side surface coupled to a front surface of the front skin and the other side surface coupled to a rear surface of the display panel.

In addition, according to another aspect of the present disclosure, the front skin may include: a first skin disposed opposite to the rear surface of the display panel; and a second skin recessed further rearwardly than the first skin and disposed opposite to the one side surface of the base.

In addition, according to another aspect of the present disclosure, there is further included a first adhesive member disposed between the one side surface of the base and a front surface of the second skin, and coupling the base and the second skin, wherein the front surface of the first skin and the front surface of the base may be disposed parallel to each other.

In addition, according to another aspect of the present disclosure, there is further included a second adhesive member disposed between the other side surface of the base and the rear surface of the display panel, and coupling the base and the display panel.

In addition, according to another aspect of the present disclosure, there are further included: a cable electrically connected to the display panel; and a mount coupled to the rear surface of the rear skin, and in which a PCB electrically connected to the cable is installed, wherein the corrugated panel may have at least one cable hole which is formed by passing through the front skin and the rear skin, and through which the cable passes.

In addition, according to another aspect of the present disclosure, the cable hole may be formed in at least any one of the front skin and the rear skin which is depressed toward the core and then is punched.

In addition, according to another aspect of the present disclosure, there is further included an adhesive member disposed between the rear surface of the rear skin and a front surface of the mount, and coupling the rear skin and the mount, wherein: the front skin further includes a third skin recessed further rearwardly than the first skin and having one side coupled to the other side of a front fastening member coupled to the mount; and the rear skin further includes a fifth skin recessed forwardly and having one side coupled to the other side of a rear fastening member coupled to the mount.

In addition, according to another aspect of the present disclosure, the frame may include a plurality of edges, each having the side wall and the base with corners formed therebetween, wherein at the corners, the base of any one of the plurality of edges may be spaced apart from the base of another one by a predetermined distance.

In addition, according to another aspect of the present disclosure, the frame may be bent a number of times corresponding to a number of the corners, to form the plurality of edges, and one end and the other end thereof may be coupled to each other to form a closed loop.

In addition, according to another aspect of the present disclosure, the one end and the other end of the frame may be coupled to each other by welding, and may be subjected to an anodizing process after finishing.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A display device comprising:
a display panel (110);
a frame (120) disposed at a rear of the display panel (110), and to which the display panel (110) is coupled; and
a corrugated panel (130) disposed at the rear of the display panel (110), and to which the frame (120) is coupled,
wherein the corrugated panel (130) comprises:
a front skin (132) forming a front surface;
a rear skin (133) forming a rear surface and disposed opposite to the front skin (132); and
a core (131) disposed between the front skin (132) and the rear skin (133), and having a corrugated shape,
wherein the display device further comprises:
a mount (140) coupled to the rear surface of the rear skin (133);
a PCB (P) mounted on the mount and electrically connected to the display panel; and
an adhesive member (AM3) disposed between the rear skin (133) and the mount (140), and fixing the mount (140) to the rear skin (133),
wherein a rear surface of the rear skin is formed to be flat,
wherein the front skin (132) further comprises:
a first skin (132a) facing a rear surface of the display panel (110);
a second skin (132b) recessed further rearwardly than the first skin (132a) and coupled with the frame (120); and
a third skin (132c) recessed further rearwardly than the first skin (132a) and coupled to a front fastening member (Ff) coupled to the mount (140), and
wherein the rear skin (133) further comprises a fifth skin (133b) recessed forwardly and coupled to a rear fastening member (Fr) coupled to the mount (140).

2. The display device of claim 1, wherein the front skin (132) and the rear skin (133) are coupled to the core sequentially from one end to the other end in a longitudinal direction of the core (131).

3. The display device of claim 1, wherein the corrugated shape is a shape with alternating ridges and grooves which are elongated.

4. The display device of claim 1, wherein the frame (120) comprises:
a side wall (121) covering a side surface of the display panel (110) and a side surface of the corrugated panel (130); and
a base (122) extending from the side wall (121), and fixed to the second skin (132b) of the front skin (132) and the rear surface of the display panel (110).

5. The display device of claim 4, further comprising a first adhesive member (AM1) disposed between the base (122) and the second skin (132b), and fixing the base (122) to the second skin (132b),
wherein a front surface of the first skin (132a) and a front surface of the base (122) are disposed parallel to each other.

6. The display device of claim 4, further comprising a second adhesive member (AM2) disposed between the base (122) and the display panel (110), and fixing the display panel (110) to the base (122).

7. The display device of claim 1, further comprising:
a cable (C) electrically connected with the display panel (110) and the PCB (P);
wherein the corrugated panel (130) has at least one cable hole (CH) which is formed by passing through the front skin (132) and the rear skin (133), and through which the cable (C) passes.

8. The display device of claim 7, wherein the hole (CH) is formed in at least any one of the front skin (132) and the rear skin (133) which is depressed toward the core and then is punched.

9. The display device of claim 4, wherein the frame (120) comprises a plurality of edges (120a, 120b, 120c, 120d), each including the side wall (121) and the base (122) with corners (Co1, Co2, Co3, Co4) formed therebetween,
wherein at the corners (Co1, Co2, Co3, Co4), the base (122) of any one of the plurality of edges (120a, 120b, 120c, 120d) is spaced apart from the base (122) of another one by a predetermined distance.

10. The display device of claim 9, wherein the frame (120) is bent a number of times corresponding to a number of the corners (Co1, Co2, Co3, Co4), to form the plurality of edges (120a, 120b, 120c, 120d), and one end (1201) and the other end (1202) thereof are coupled to each other to form a closed loop.

11. The display device of claim 10, wherein the one end (1201) and the other end (1202) of the frame (120) are coupled to each other by welding, and are subjected to an anodizing process after finishing.

## Patentansprüche

1. Anzeigevorrichtung aufweisend:
eine Anzeigetafel (110);
einen Rahmen (120), der an einer Rückseite der Anzeigetafel (110) angeordnet ist und mit dem die Anzeigetafel (110) gekoppelt ist; und
eine gewellte Tafel (130), die an der Rückseite der Anzeigetafel (110) angeordnet ist und mit der der Rahmen (120) gekoppelt ist,
wobei die gewellte Tafel (130) aufweist:
eine vordere Haut (132), die eine vordere Fläche bildet;
eine hintere Haut (133), die eine hintere Fläche bildet und gegenüber der vorderen Haut (132) angeordnet ist; und
einen Kern (131), der zwischen der vorderen Haut (132) und der hinteren Haut (133) angeordnet ist und eine gewellte Form aufweist,
wobei die Anzeigevorrichtung ferner aufweist:
eine Halterung (140), die mit der hinteren Fläche der hinteren Haut (133) gekoppelt ist;
eine Leiterplatte (P), die auf der Halterung montiert und elektrisch mit der Anzeigetafel verbunden ist; und
ein Klebeelement (AM3), das zwischen der hinteren Haut (133) und der Halterung (140) angeordnet ist und die Halterung (140) an der hinteren Haut (133) befestigt,
wobei eine hintere Fläche der hinteren Haut flach ausgebildet ist,
wobei die vordere Haut (132) ferner aufweist:
eine erste Haut (132a), die einer hinteren Fläche der Anzeigetafel (110) zugewandt ist;
eine zweite Haut (132b), die weiter nach hinten ausgespart ist als die erste Haut (132a) und mit dem Rahmen (120) gekoppelt ist; und
eine dritte Haut (132c), die weiter nach hinten ausgespart ist als die erste Haut (132a) und mit einem vorderen Befestigungselement (Ff) gekoppelt ist, das mit der Halterung (140) gekoppelt ist, und
wobei die hintere Haut (133) ferner eine fünfte Haut (133b) aufweist, die nach vorne ausgespart ist und mit einem hinteren Befestigungselement (Fr) gekoppelt ist, das mit der Halterung (140) gekoppelt ist.

2. Anzeigevorrichtung nach Anspruch 1, wobei die vordere Haut (132) und die hintere Haut (133) in einer Längsrichtung des Kerns (131) nacheinander von einem Ende zum anderen Ende mit dem Kern gekoppelt sind.

3. Anzeigevorrichtung nach Anspruch 1, wobei die gewellte Form eine Form mit abwechselnden Rippen und Rillen ist, die länglich sind.

4. Anzeigevorrichtung nach Anspruch 1, wobei der Rahmen (120) aufweist:
eine Seitenwand (121), die eine Seitenfläche der Anzeigetafel (110) und eine Seitenfläche der gewellten Tafel (130) bedeckt; und
eine Basis (122), die sich von der Seitenwand (121) erstreckt und an der zweiten Haut (132b) der vorderen Haut (132) und der hinteren Fläche der Anzeigetafel (110) befestigt ist.

5. Anzeigevorrichtung nach Anspruch 4, die ferner ein erstes Klebeelement (AM1) aufweist, das zwischen der Basis (122) und der zweiten Haut (132b) angeordnet ist und die Basis (122) an der zweiten Haut (132b) befestigt,
wobei eine vordere Fläche der ersten Haut (132a) und eine vordere Fläche der Basis (122) parallel zueinander angeordnet sind.

6. Anzeigevorrichtung nach Anspruch 4, die ferner ein zweites Klebeelement (AM2) aufweist, das zwischen der Basis (122) und der Anzeigetafel (110) angeordnet ist und die Anzeigetafel (110) an der Basis (122) befestigt.

7. Anzeigevorrichtung nach Anspruch 1, die ferner aufweist:
ein Kabel (C), das elektrisch mit der Anzeigetafel (110) und der Leiterplatte (P) verbunden ist;
wobei die gewellte Tafel (130) mindestens ein Kabelloch (CH) aufweist, das so geformt ist, dass es durch die vordere Haut (132) und die hintere Haut (133) hindurchgeht, und durch das das Kabel (C) hindurchgeht.

8. Anzeigevorrichtung nach Anspruch 7, wobei das Loch (CH) in der vorderen Haut (132) und/oder der hinteren Haut (133) ausgebildet ist, die zum Kern hin eingedrückt und dann gestanzt wird.

9. Anzeigevorrichtung nach Anspruch 4, wobei der Rahmen (120) mehrere Kanten (120a, 120b, 120c, 120d) aufweist, die jeweils die Seitenwand (121) und die Basis (122) mit dazwischen gebildeten Ecken (Co1, Co2, Co3, Co4) einschließen,
wobei an den Ecken (Co1, Co2, Co3, Co4) die Basis (122) einer beliebigen der mehreren Kanten (120a, 120b, 120c, 120d) von der Basis (122) einer anderen um einen vorbestimmten Abstand beabstandet ist.

10. Anzeigevorrichtung nach Anspruch 9, wobei der Rahmen (120) eine Anzahl von Malen gebogen ist, die einer Anzahl der Ecken (Co1, Co2, Co3, Co4) entspricht, um die mehreren Kanten (120a, 120b, 120c, 120d) zu bilden, und ein Ende (1201) und das andere Ende (1202) davon miteinander gekoppelt sind, um eine geschlossene Schleife zu bilden.

11. Anzeigevorrichtung nach Anspruch 10, wobei das eine Ende (1201) und das andere Ende (1202) des Rahmens (120) durch Schweißen miteinander gekoppelt werden und nach der Fertigstellung einem Eloxierverfahren unterzogen werden.

## Revendications

1. Dispositif d'affichage, comprenant :
un panneau d'affichage (110) ;
un cadre (120) disposé à l'arrière du panneau d'affichage (110) et auquel le panneau d'affichage (110) est raccordé ; et
un panneau ondulé (130) disposé à l'arrière du panneau d'affichage (110) et auquel le cadre (120) est raccordé,
où le panneau ondulé (130) comprend :
une pellicule avant (132) formant une surface avant ;
une pellicule arrière (133) formant une surface arrière et disposée à l'opposé de la pellicule avant (132) ; et
un noyau (131) disposé entre la pellicule avant (132) et la pellicule arrière (133), et ayant une forme ondulée,
où le dispositif d'affichage comprend en outre :
une monture (140) raccordée à la surface arrière de la pellicule arrière (133) ;
un circuit imprimé (P) monté sur la monture et connecté électriquement au panneau d'affichage ; et
un élément adhésif (AM3) disposé entre la pellicule arrière (133) et la monture (140), et fixant la monture (140) à la pellicule arrière (133),
où une surface arrière de la pellicule arrière est formée de manière à être plane,
où la pellicule avant (132) comprend en outre :
une première pellicule (132a) faisant face à une surface arrière du panneau d'affichage (110) ;
une deuxième pellicule (132b) plus en retrait vers l'arrière que la première pellicule (132a) et raccordée au cadre (120) ; et
une troisième pellicule (132c) en retrait vers l'arrière par rapport à la première pellicule (132a) et raccordée à un élément de fixation avant (Ff) raccordé à la monture (140), et
où la pellicule arrière (133) comprend en outre une cinquième pellicule (133b) en retrait vers l'avant et raccordée à un élément de fixation arrière (Fr) raccordé à la monture (140).

2. Dispositif d'affichage selon la revendication 1, où la pellicule avant (132) et la pellicule arrière (133) sont raccordées séquentiellement au noyau d'une extrémité à l'autre extrémité dans le sens de la longueur du noyau (131).

3. Dispositif d'affichage selon la revendication 1, où la forme ondulée est une forme où alternent des crêtes et des sillons allongés.

4. Dispositif d'affichage selon la revendication 1, où le cadre (120) comprend :
une paroi latérale (121) recouvrant une surface latérale du panneau d'affichage (110) et une surface latérale du panneau ondulé (130) ; et
une base (122) s'étendant depuis la paroi latérale (121) et fixée à la deuxième pellicule (132b) de la pellicule avant (132) et à la surface arrière du panneau d'affichage (110).

5. Dispositif d'affichage selon la revendication 4, comprenant en outre un premier élément adhésif (AM1) disposé entre la base (122) et la deuxième pellicule (132b), et fixant la base (122) à la deuxième pellicule (132b),
où une surface avant de la première pellicule (132a) et une surface avant de la base (122) sont disposées parallèlement l'une à l'autre.

6. Dispositif d'affichage selon la revendication 4, comprenant en outre un deuxième élément adhésif (AM2) disposé entre la base (122) et le panneau d'affichage (110), et fixant le panneau d'affichage (110) à la base (122).

7. Dispositif d'affichage selon la revendication 1, comprenant en outre :
un câble (C) connecté électriquement au panneau d'affichage (110) et au circuit imprimé (P) ;
où le panneau ondulé (130) comporte au moins un orifice de câble (CH) formé en traversant la pellicule avant (132) et la pellicule arrière (133) et dans lequel passe le câble (C).

8. Dispositif d'affichage selon la revendication 7, où l'orifice (CH) est formé dans au moins une des parois, avant (132) et arrière (133), enfoncée vers le noyau avant d'être percée.

9. Dispositif d'affichage selon la revendication 4, où le cadre (120) comprend une pluralité de bords (120a, 120b, 120c, 120d) comportant chacun la paroi latérale (121) et la base (122) avec des coins (Co1, Co2, Co3, Co4) formés entre eux,
où, dans les coins (Co1, Co2, Co3, Co4), la base (122) d'un bord quelconque de la pluralité (120a, 120b, 120c, 120d) est espacée d'une distance prédéterminée de la base (122) d'un autre bord.

10. Dispositif d'affichage selon la revendication 9, où le cadre (120) est plié un nombre de fois correspondant au nombre de coins (Co1, Co2, Co3, Co4) pour former la pluralité de bords (120a, 120b, 120c, 120d), et une extrémité (1201) et l'autre extrémité (1202) de celui-ci sont raccordées l'une à l'autre pour former une boucle fermée.

11. Dispositif d' affichage selon la revendication 10, où la première extrémité (1201) et l'autre extrémité (1202) du cadre (120) sont raccordées l'une à l'autre par soudage, et sont soumises à un processus d'anodisation après finition.
